# EUROPÄISCHE PATENTSCHRIFT

(11) **EP 0 452 641 B1**
(45) Veröffentlichungstag und Bekanntmachung des Hinweises auf die Patenterteilung: **05.10.1994**
(21) Anmeldenummer: 91102897.5
(22) Anmeldetag: 28.02.1991
(51) Int. Cl.: H05K 7/12

(54) **Steckbares Befestigungselement für Leiterplatten**
Plug-in fixing element for printed circuit boards
Eléments de fixation enfichables pour circuits imprimés

(30) Priorität: 14.04.1990 DE 4012217
(43) Veröffentlichungstag der Anmeldung: 23.10.1991
(73) Patentinhaber: DIETER HÖLZLE TECHNIK-PROJEKTE GmbH, 75392 Deckenpfronn (DE)
(72) Erfinder: Hölzle, Dieter, W-7268 Gechingen (DE)
(74) Vertreter: Ott, Elmar, Dipl.-Ing.

(56) Entgegenhaltungen:
- GB-A- 2 212 001
- US-A- 3 880 486
- US-A- 4 495 548

## Beschreibung

Die Erfindung betrifft ein steckbares Befestigungselement für Leiterplatten gemäß der Gattung des Hauptanspruchs.

Derartige Befestigungselemente sind aus GB-A-2212001 bereits bekannt.

Befestigungselemente, die in Durchgangsbohrungen von Leiterplatten einsetzbar sind, können als sogenannte Snap-In-Verbindungen ausgeführt sein. Für eine sichere Befestigung von mechanisch beanspruchten Bauteilen oder von Bauteilen mit verhältnismäßig großem Gewicht, sind diese bekannten Befestigungen nicht geeignet. Aus diesem Grund werden beispielsweise Steckerleisten mittels Schrauben oder Nieten auf Leiterplatten befestigt, um eine stabile Verbindung zu erhalten. Schraubverbindungen und Nietverbindungen sind verhältnismäßig teuer, insbesondere da bei der Montage hierfür ein hoher Zeitaufwand erforderlich ist.

Der Erfindung liegt die Aufgabe zugrunde, ein steckbares Befestigungselement für Leiterplatten oder drgl. zu schaffen, welches mit einem möglichst geringen Zeitaufwand montierbar ist.

Die Lösung dieser Aufgabe erhält man durch die im Hauptanspruch angegebenen Merkmale.

Im Freiraum zwischen den Rastschenkeln des Kunststoffkörpers befindet sich ein lötfähiges Element, beispielsweise ein Metallstift oder ein flaches Metallplättchen. Das lötfähige Element wird dabei so angeordnet, daß zwischen den angrenzenden Rastschenkeln noch ein geringer Freiraum verbleibt, in den bei einem Lötvorgang Lot eindringen kann. Dieser Lötvorgang kann von Hand mittels Lötzinn und Lötkolben ausgeführt werden, jedoch besteht der Hauptvorteil darin, daß das Verlöten auch im Lötbad vollautomatisch durchgeführt werden kann. Dabei ist es besonders wichtig, daß die Kunststoff-Rastschenkel das zu befestigende Bauteil an der Leiterplatte vorfixieren, damit die Lötwelle des Lötbades das Befestigungselement nicht aus dem Bohrloch herausdrückt. Selbstverständlich wird als Kunststoff für das Befestigungselement ein ausreichend temperaturbeständiger Kunststoff verwendet, da beim Lötvorgang Temperaturen um 230° C auftreten können. Polyester, Polyamid oder Polycarbonat sind geeignete Kunststoffe, die diese Lötbadtemperaturen zumindest für die kurze Lötdauer, die ca. 3 Sekunden beträgt, völlig unbeschadet überstehen.

Beim Lötvorgang steigt das flüssige Lot am lötfähigen Element hoch, wodurch der Freiraum zwischen den Rastschenkeln durch einen Keil aus Lötmaterial völlig ausgefüllt wird. Es entsteht somit eine formschlüssige Verbindung zwischen Befestigungselement und Leiterplatte. Die Verbindung kann jedoch auch problemlos bei Bedarf wieder gelöst werden. Hierzu muß lediglich das Lot erwärmt und mittels einer herkömmlichen Absaugvorrichtung aus dem Freiraum abgesaugt werden. Die Rastschenkel lassen sich dann wieder zusammendrücken, so daß das Befestigungselement bzw. das mit ihm verbundene Bauteil wieder von der Leiterplatte abgenommen werden kann.

Das lötfähige Element kann ein flaches Metallteil oder ein Metallstift sein. Bei einer Ausführung als flaches Metallteil wird dieses gegenüber den Rastschenkeln um 90° versetzt zwischen diesen angeordnet, wobei auch das Metallteil außen am Bohrlochrand angreifende Rastfahnen aufweisen kann. Die Vorfixierung und die exakte Zentrierung des Befestigungselement im Bohrloch kann somit durch die metallischen Rastfahnen zusätzlich unterstützt werden. Außerdem können die den unteren Rand der Durchgangsbohrung der Leiterplatte berührenden Rastfahnen mit angrenzenden Leiterbahnen verlötet werden, so daß das Metallteil zusätzlich als elektrische Masseverbindung für ein zu befestigendes Bauelement dienen kann. Auch eine andere elektrische Verbindung kann somit über das lötfähige Element hergestellt werden.

Um eine elektrische Verbindung beim Lötvorgang zwischen dem mittleren Metallteil und den an der Durchgangsbohrung der Leiterplatte angrenzenden Leiterbahnen sicher zu vermeiden, kann weiterhin vorgesehen sein, daß im unteren Abschnitt das Metallteil eine gegenüber dem Durchmesser der Durchgangsbohrung reduzierte Breite hat. Dadurch wird sichergestellt, daß im Randbereich der Durchgangsbohrung ein deutlicher Abstand zum Metallteil eingehalten wird, der eine Lötverbindung zu angrenzenden Leiterbahnen verhindert.

Durch einen an den Rastschenkeln ausgebildeten Rastrand wird sichergestellt, daß eine gute Vorfixierung des zunächst lediglich in die Durchgangsbohrung eingesteckten Befestigungselements erzielt wird. Erst
durch den Lötvorgang wird dann eine formschlüssige Verbindung erhalten, da die Rastschenkel sich dann nicht mehr nach innen drücken lassen.

Eine bevorzugte Ausführungsform der Erfindung sieht vor, daß die Rastschenkel jeweils ein Segment einer zylindrischen Mantelfläche bilden, die als Anlagefläche für die Bohrlochwand der Durchgangsbohrung dient. Dabei können die Rastschenkel jeweils ein Segment bilden, welches über einen Winkelbereich von etwa 100° an der Bohrlochwandung anliegt. Bereits zwei gegenüberliegende Rastschenkel mit derart ausgebildeten Anlageflächen zentrieren das Befestigungselement sehr genau in der Durchgangsbohrung, so daß weitere Zentrierelemente nicht erforderlich sind.

Weiterhin kann an der unteren Anlagefläche des überstehenden Randes des Befestigungselements ein federelastisches Element angeordnet sein, welches als Toleranzausgleichselement dienen kann. Zwischen dem Federelement und dem Rand kann ein zu befestigendes Teil eingespannt sein, wobei das zu befestigende Teil bezüglich seiner Dicke höhere Toleranzen aufweisen kann als bei Verwendung eines Befestigungselements ohne Toleranzausgleichselemente. Das lötfähige Element kann vom Kunststoffmaterial des Befestigungselements umspritzt sein. Auf diese Weise erhält man eine sehr stabile und sehr einfach herstellbare Verbindung zwischen lötfähigem Element und dem Kunststoffteil des Befestigungselements.

Die Erfindung wird nachfolgend anhand der Zeichnung näher erläutert.

Es zeigen:
Figur 1 das in eine Leiterplatte eingesetzte Befestigungselement von unten,
Figur 2 das in eine Leiterplatte eingesetzte Befestigungselement gemäß Figur 1 im Querschnitt,
Figur 3 das Befestigungselement im Schnitt entsprechend der Schnittlinie AB von Figur 2,
Figur 4 eine weitere Ausführungsform eines erfindungsgemäßen Befestigungselements,
Figur 5 den oberen Teil einer weiteren Ausführungsform mit Toleranzausgleichselement und
Figur 6 eine weitere Ausführung mit einem als zusätzliches Rastelement ausgebildeten lötfähigem Element.

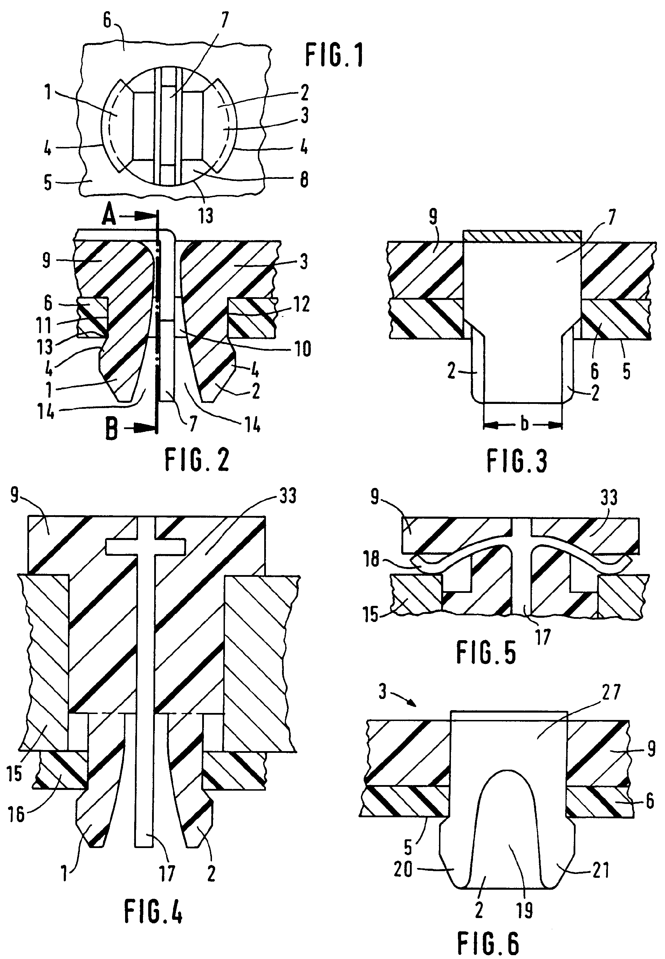

Figur 1 zeigt die Rastschenkel 1, 2 eines Befestigungselements 3 von unten. Mit einem überstehenden Rand 4 greifen die Rastschenkel 1, 2 an der Unterseite 5 einer Leiterplatte 6 an. In der Mitte zwischen den Rastschenkeln 1, 2 steht ein metallisches Element 7 ab, das - wie in Figur 2 ersichtlich - etwa gleichweit absteht wie die benachbarten Rastschenkel 1, 2.

In Figur 1 ist der verbleibende Freiraum zwischen den Rastschenkeln 1, 2 mit Lot 8 ausgefüllt, so daß sich die Rastschenkel 1, 2 nicht mehr nach innen zusammendrücken lassen. In Figur 2 ist dieser Freiraum zur besseren Darstellung des Befestigungselements 3 nicht mit Lot ausgefüllt.

Das in Figur 2 dargestellte Befestigungselement 3 weist an seiner Oberseite einen überstehenden Rand 9 auf, der Teil eines Steckers oder eines sonstigen Bauelements sein kann. Mit diesem Rand 9 liegt das Befestigungselement 3 an der Oberseite der Leiterplatte 6 an und greift mit den Rastschenkeln 1, 2 durch eine Durchgangsbohrung 10. Das lötfähige Element 7, welches als dünnwandiges Metallteil ausgeführt ist, ist oben am Befestigungselement 3 herausgeführt und kann zu einer hier nicht dargestellten Abschirmung oder zu einem elektrischen Anschluß führen.

Die Rastschenkel 1, 2 weisen Anlageflächen 11, 12 auf, die jeweils ein Segment einer zylindrischen Mantelfläche bilden und an der Wandung der Durchgangsbohrung 10 über einen Winkelbereich von etwa 100° anliegen. Das Befestigungselement wird somit durch die Mantelflächen der Rastschenkel 1, 2 in der Durchgangsbohrung 10 zentriert. Der überstehende Rand 4 rastet am unteren Rand 13 der Durchgangsbohrung 10 ein, wodurch das Befestigungselement 3 gegen unbeabsichtigtes Herausfallen gesichert ist. Wird nun Lot in den Freiraum 14 eingebracht, so bildet das Lot nach Abkühlung einen Keil, der ein Zusammendrücken der Rastschenkel 1, 2 verhindert. Das Befestigungselement 3 ist dann formschlüssig in der Leiterplatte 6 befestigt.

In Figur 3 ist insbesondere ersichtlich, daß das flache Metallteil 7 im unteren Bereich eine reduzierte Breite b aufweist, damit ein deutlicher Abstand zwischen Metallteil 7 und Unterseite 5 der Leiterplatte 6 eingehalten wird.

In Figur 4 ist ein Befestigungselement 33 gezeigt, welches mit seinem Rand 9 einen zu befestigenden Gegenstand 15 an einer Platte 16 festhält. Das Metallteil 17 ist von dem Kunststoffmaterial des Befestigungselements 33 im oberen Bereich umspritzt.

In Figur 5 ist zwischen dem Rand 9 und dem zu befestigenden Teil 15 ein als Toleranzausgleichselement dienendes Federelement 18 angeordnet, welches unmittelbar am Metallteil 17 absteht.

In Figur 6 ist eine weitere Ausführungsform eines Metallteils 27 gezeigt, bei dem eine Aussparung 19 vorgesehen ist, die von zwei seitlichen Rastfahnen 20, 21 begrenzt ist. Wird das Befestigungselement 3 mit einem derart ausgebildeten Metallteil 27 durch ein Lötbad geschickt, so kann eine Lötverbindung zwischen den Rastfahnen 20, 21 und angrenzenden Leiterbahnen an der Unterseite 5 der Leiterplatte 6 gebildet werden.

Der Erfindungsgegenstand ist nicht beschränkt auf die Anwendung bei Leiterplatten, sondern kann grundsätzlich als Befestigungselement für den Einsatz in Platten mit Durchgangsbohrungen Verwendung finden. Bei der Anwendung in Leiterplatten kann das Lot in einem Arbeitsgang zusammen mit dem ohnehin erforderlichen Verlöten der übrigen Bauteile in einem Lötbad erfolgen. Das Befestigungselement läßt sich gleichermaßen wie elektrische Bauteile mittels Bestückungsautomaten in Leiterplatten einsetzen und erfordert dann keine zusätzliche Montagearbeit mehr, wenn ein Verlöten im Lötbad ohnehin erfolgt.

Die Rastschenkel 1, 2 bestehen aus einem ausreichend temperaturbeständigen Kunststoff, der die bei Lötbädern übliche Temperatur von etwa 220° bis 240° C ohne Beeinträchtigung übersteht. Beim Lötvorgang steigt das Lot an dem Metallteil 7, 17, 27 nach oben, wodurch der Freiraum zwischen den Kunststoff-Rastschenkeln 1, 2 bis sehr weit nach oben ausgefüllt wird. Ein vollständiges Ausfüllen des Freiraums 14 wird dadurch begünstigt, daß sich der Freiraum 14 nach oben verjüngt.

## Patentansprüche

1. Steckbares Befestigungselement (3;33) für Leiterplatten oder dgl., das einen Kunststoffkörper mit einem, an seinem einen Ende, seitlich überstehenden Rand hat, an dem wenigstens zwei gegenüberliegende radialelastische Rastschenkel (1, 2) aus Kunststoff abstehen, die beim Einführen in eine Durchgangsbohrung zusammengedrückt werden und federnd in der Endposition an der Leiterplatte (6) einrasten, **dadurch gekennzeichnet,** daß im Freiraum (14) zwischen den Rastschenkeln (1, 2) ein lötfähiges Element (7;17;27) absteht, das zu beiden Rastschenkeln (1, 2) vorzugsweise den gleichen Abstand aufweist.

2. Befestigungselement nach Anspruch 1, **dadurch gekennzeichnet,** daß das abstehende freie Ende des lötfähigen Elements (7) sich auf gleicher Ebene befindet wie die abstehenden Enden der Rastschenkel (1, 2).

3. Befestigungselement nach einem der Ansprüche 1 oder 2, **dadurch gekennzeichnet,** daß das lötfähige Element ein flaches Metallteil (7; 27) oder ein Metallstift ist.

4. Befestigungselement nach einem der vorhergehenden Ansprüche, **dadurch gekennzeichnet,** daß das als flaches Metallteil (7; 27) ausgebildete lötfähige Element in seiner Mitte eine Aussparung (19) hat, die von elastischen Rastfahnen (20, 21) begrenzt ist.

5. Befestigungselement nach einem der Ansprüche 1 bis 3, **dadurch gekennzeichnet,** daß das als flaches Metallteil (7,) ausgebildete lötfähige Element im unteren Abschnitt eine reduzierte Breite (b) hat und nur im oberen Teilbereich der Durchgangsbohrung (10) der Leiterplatte (6) an der Bohrlochwandung anliegt.

6. Befestigungselement nach einem der vorhergehenden Ansprüche, **dadurch gekennzeichnet,** daß die Rastschenkel (1, 2) an ihren abstehenden Enden einen nach außen überstehenden Rastrand (4) haben.

7. Befestigungselement nach einem der vorhergehenden Ansprüche, **dadurch gekennzeichnet,** daß die Rastschenkel (1, 2) jeweils ein Segment einer zylindrischen Mantelfläche bilden, die als Anlagefläche (11, 12) für die Bohrlochwand der Durchgangsbohrung (10) dient.

8. Befestigungselement nach einem der vorhergehenden Ansprüche, **dadurch gekennzeichnet,** daß an der Unterseite des oberen Randes (9) des Befestigungselements (33) Federelemente als axiale Toleranzausgleichselemente (18) angeordnet sind.

9. Befestigungselement nach einem der vorhergehenden Ansprüche, **dadurch gekennzeichnet,** daß das lötfähige Element (17) vom Kunststoffteil formschlüssig umgeben ist.

10. Befestigungselement nach einem der vorhergehenden Ansprüche, **dadurch gekennzeichnet,** daß das lötfähige Element (7) an der Oberseite des Befestigungselements (3) als elektrischer Leiter herausgeführt ist.

11. Herstellung einer Verbindung mit einem Befestigungselement nach einem der vorhergehenden Ansprüchen, **dadurch gekennzeichnet,** daß das Befestigungselement (3;33) in eine Durchgangsbohrung (10) eingesetzt wird, das dann die Unterseite der Leiterplatte (6) über eine Lötwelle eines Lötbades bewegt wird, wobei das Lot in den Freiraum (14) zwischen den Rastschenkeln (1, 2) eindringt und nach Abkühlung einen Keil und damit eine formschlüssige Verbindung zwischen Befestigungselement (3;33) und Leiterplatte (6) bildet.

## Claims

1. Pluggable fastening element (3,33) for printed circuit boards or the like, which has a plastic body having a laterally projecting edge at its one end and from which project at least two facing, radial elastic, plastic locking legs (1,2), which are pressed together on introduction into a through hole and resiliently lock in the end position on the printed circuit board (6), characterized in that in the free space (14) between the locking legs (1,2) projects a solderable element (7,17,27), which preferably has the same spacing with respect to the two locking legs (1,2).

2. Fastening element according to claim 1, characterized in that the projecting free end of the solderable element (7) is on the same plane as the projecting ends of the locking legs (1,2).

3. Fastening element according to one of the claims 1 or 2, characterized in that the solderable element is a flat metal part (7,27) or a metal pin.

4. Fastening element according to one of the preceding claims, characterized in that the solderable element constructed as a flat metal part (7,27) has in its centre a recess (19), which is bounded by elastic locking lugs (20,21).

5. Fastening element according to one of the claims 1 to 3, characterized in that the solderable element constructed as a flat metal part (7) has in its lower portion a reduced width (b) and only in the upper portion of the through-hole (10) of the printed circuit board (6) engages on the wall of the hole.

6. Fastening element according to one of the preceding claims, characterized in that on their projecting ends the locking legs (1,2) have an outwardly projecting locking edge (4).

7. Fastening element according to one of the preceding claims, characterized in that the locking legs (1,2) in each case form a segment of a cylindrical circumferential surface, which serves as a contact surface (11,12) for the wall of the through-hole (10).

8. Fastening element according to one of the preceding claims, characterized in that on the underside of the upper edge (9) of the fastening element (33) are provided spring elements as axial tolerance compensating elements (18).

9. Fastening element according to one of the preceding claims, characterized in that the conductive element (17) is positively surrounded by the plastic part.

10. Fastening element according to one of the preceding claims, characterized in that the conductive element (7) passes out as an electrical conductor on the top of the fastening element (3).

11. Manufacture of a connection with a fastening element according to one of the preceding claims, characterized in that the fastening element (3,33) is inserted in a through-hole (10), that then the underside of the printed circuit board (6) is moved over a solder wave of a solder bath, the solder penetrating the free space (14) between the locking legs (1,2) and after cooling forms a wedge and therefore a positive connection between the fastening element (3,33) and the printed circuit board (6).

## Revendications

1. Élément de fixation enfichable (3 ; 33) pour plaquettes de circuits imprimés ou analogues, qui comprend un corps en matière plastique muni d'un bord faisant saillie latéralement à l'une de ses extrémités, duquel partent au moins deux griffes encliquetables (1, 2) en matière plastique qui, en les introduisant dans un perçage de passage, sont comprimées et s'enclenchent dans la position finale sur la plaquette de circuits imprimés (6) en faisant ressort, caractérisé en ce qu'un élément brasable
(7; 17; 27) présentant, de préférence, le même écart par rapport aux deux griffes encliquetables (1, 2) fait saillie dans l'espace libre (14) situé entre les griffes encliquetables (1, 2).

2. Élément de fixation selon la revendication 1, caractérisé en ce que l'extrémité libre saillante de l'élément brasable (7) se situe au même niveau que les extrémités saillantes des griffes encliquetables (1, 2).

3. Élément de fixation selon l'une des revendications 1 et 2, caractérisé en ce que l'élément brasable est une pièce en métal plate (7 ; 27) ou une broche métallique.

4. Élément de fixation selon l'une des revendications précédentes, caractérisé en ce que l'élément brasable réalisé en tant que pièce en métal plate (7 ; 27) présente en son milieu un évidement (19) qui est délimité par des lames encliquetables (20, 21) élastiques.

5. Élément de fixation selon l'une des revendications 1 à 3, caractérisé en ce que l'élément brasable réalisé en tant que pièce en métal plate (7) a une largeur (b) réduite dans la partie inférieure et n'est appliqué contre la paroi du perçage que dans la partie supérieure du perçage de passage (10) de la plaquette de circuits imprimés (6).

6. Élément de fixation selon l'une des revendications précédentes, caractérisé en ce que les griffes encliquetables (1, 2) comportent au niveau de leurs extrémités saillantes un bord d'encliquetage (4) faisant saillie vers l'extérieur.

7. Élément de fixation selon l'une des revendications précédentes, caractérisé en ce que les griffes encliquetables (1, 2) forment chacune un segment d'une surface latérale cylindrique qui sert de surface de contact (11, 12) pour la paroi du perçage de passage (10).

8. Élément de fixation selon l'une des revendications précédentes, caractérisé en ce que des éléments à ressort sont disposés en tant qu'éléments de compensation des tolérances (18) sur la face inférieure du bord supérieur (9) de l'élément de fixation (33).

9. Élément de fixation selon l'une des revendications précédentes, caractérisé en ce que l'élément brasable (17) est entouré avec un engagement positif par la pièce en matière plastique.

10. Élément de fixation selon l'une des revendications précédentes, caractérisé en ce que l'élément brasable (7) sort en tant que conducteur électrique sur le dessus de l'élément de fixation (3).

11. Établissement d'une liaison avec l'élément de fixation selon l'une des revendications précédentes, caractérisé en ce que l'élément de fixation (3 ; 33) est placé dans un perçage de passage (10), en ce que la face inférieure de la plaquette de circuits imprimés (6) est ensuite déplacé par le biais d'une vague d'un bain de brasage, sachant que le métal d'apport de brasage pénètre dans l'espace libre (14) entre les griffes encliquetables (1, 2) et, une fois refroidi, forme une clavette et donc un assemblage à engagement positif entre l'élément de fixation (3 ; 33) et la plaquette de circuits imprimés (6).
